# EUROPÄISCHE PATENTANMELDUNG

(11) **EP 3 648 150 A1**
(43) Veröffentlichungstag der Anmeldung: **06.05.2020**
(21) Anmeldenummer: 18203938.8
(22) Anmeldetag: 01.11.2018
(51) Int. Cl.: H01L 21/67, H01L 21/68, B25J 9/16, H01L 21/677

(54) **VERFAHREN ZUM ANLERNEN ODER KONTROLLIEREN EINES ROBOTERS SOWIE HIERFÜR VERWENDETES SYSTEM**

(71) Anmelder: Integrated Dynamics Engineering GmbH, 65479 Raunheim (DE)
(72) Erfinder: Birkner, Andreas, 07743 Jena (DE)
(74) Vertreter: Blumbach · Zinngrebe Patentanwälte PartG mbB

(57) **Zusammenfassung**

Verfahren zum Anlernen oder Kontrollieren eines Roboters zum Bewegen eines Wafers oder einer Maske, wobei zumindest eine Kamera verwendet wird, die die Bewegung des Roboters oder des Wafers oder der Maske aufnimmt. Das Verfahren wird insbesondere für das Teach-In eines Roboters mit einem Endeffektor zum Transportieren eines Wafers bzw. einer Maske verwendet.

## Beschreibung

### Gebiet der Erfindung

Die Erfindung betrifft ein Verfahren zum Anlernen oder Kontrollieren eines Roboters zum Bewegen eines Wafers oder einer Maske sowie ein zur Ausführung des Verfahrens ausgebildetes System. Die Erfindung betrifft also insbesondere ein Verfahren, welches zum Anlernen oder Kontrollieren eines Roboters zur Prozessierung von Halbleiterbauelementen verwendet wird.

### Hintergrund der Erfindung

In Anlagen zur Prozessierung von Halbleiterbauelementen werden Roboter verwendet. Insbesondere ist es gängig, dass mittels eines Roboters, welcher einen sogenannten Endeffektor zum Greifen und Ablegen eines Wafers oder einer Maske hat, die zu prozessierenden Teile zu Bearbeitungsstationen bewegt werden. Derartige Roboter bewegen den Endeffektor in der Regel in mehreren Raumrichtungen und es ist bei einer Anlage zur Prozessierung von Halbleiterbauelementen nötig, den Roboter anzulernen, also die Trajektorie einer Bewegungskurve einzuspeichern.

Bei dem sogenannten "Teach-in" wird ein Roboter mit einem Bewegungsablauf angelernt und/oder mechanisch justiert, welchen er sodann im Betrieb der Anlage weiter ausführt. Insbesondere wird beim Teach-In eine Zielposition angelernt, in welcher das Substrat vom Roboter abgelegt wird. Das Teach-in wird bei vielen Robotern manuell bei angeschalteten Motorachsen durchgeführt. Zumeist erfolgt der Teach-in-Vorgang unter optischer Kontrolle durch einen Bediener und die Bewegungskurve wird durch eine Vielzahl kleinerer Einzelschritte, insbesondere der Radial- und Theta-Bewegungen, durchgeführt. Oft sind dabei zwei Bediener erforderlich, da beim Teach-in-Vorgang zwei oder mehr Richtungen oder Freiheitsgrade optisch überwacht werden müssen, um Kollisionen zu vermeiden.

Bei Fehlern des Bedieners können größere Schäden entstehen. Weiter ist die Sicht des Bedieners, der die Bewegung des Roboters optisch überwacht, vielfach eingeschränkt. Dies gilt insbesondere in Vakuum-Kammern.

Weiterhin ist der Vorgang des Teach-In, oder der vorzugsweise regelmäßig durchgeführten Kontrolle des korrekten Teach-In zumeist damit verbunden, dass die Anlage geöffnet werden muss, wodurch sie außer Betrieb genommen werden muss, was entsprechende Ausfallzeiten erzeugt. Es muss dazu das sogenannte Minienvironment der Anlage geöffnet werden muss, wodurch die Anlage verunreinigt wird, was wiederum zusätzliche Ausfallzeiten der Maschine verursacht, um danach die erforderliche Sauberkeit in der Anlage wiederherzustellen.

Ein ungenaues Teach-In führt kann zu erhöhter Partikelgenerierung führen und damit zu verringerter Ausbeute des Prozesses, in welchem die Anlage verwendet wird. Ungenaues Teach-In kann ebenfalls zu Fehlern durch zu große Fehlablagen des Substrats, insbesondere Wafer, Maske, und/oder Flat-Panel-Display-Substrats führen.

### Aufgabe der Erfindung

Der Erfindung liegt demgegenüber die Aufgabe zugrunde, das Anlernen oder Kontrollieren eines Roboters zum Bewegen eines Wafers oder einer Maske oder eines Flat-Panel Displays zu vereinfachen.

### Zusammenfassung der Erfindung

Die Aufgabe der Erfindung wird bereits durch ein Verfahren zum Anlernen und/oder Kontrollieren eines Roboters sowie durch ein zur Ausführung des Verfahrens ausgebildetes System nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft ein Verfahren zum Anlernen und/oder Kontrollieren eines Roboters zum Bewegen eines Substrats eines Wafers oder eines Flat-Panel-Displays, also eines Substrats für einen Flachbildschirm, oder einer Maske, also einer fotolithographischen Maske.

Das Verfahren beinhaltet insbesondere den Teach-in-Vorgang und/oder die Kontrolle einer Zielposition eines Roboters zur Prozessierung von Halbleiterbauelementen.

Gemäß der Erfindung wird zumindest eine Kamera verwendet, die die Bewegung des Roboters und/oder des Wafers oder der Maske für die Belichtung des Wafers und/oder eines Flat-panel-Displays aufnimmt.

Der Erfindung liegt also das Grundprinzip zugrunde, dass statt einer visuellen Kontrolle der Bewegungskurve eine Kamera verwendet wird, um den Roboter anzulernen oder zu kontrollieren.

Weiter liegt einer Ausführungsform der Erfindung die Kontrolle der Zielposition des vom Roboter bewegten Substrats zugrunde.

Unter der Bewegungskurve wird insbesondere die Bewegungskurve eines Arms eines Roboters, insbesondere eines Endeffektors und insbesondere bezüglich der Radial-und Theta-Bewegungen, verstanden. Weiter kann auch der Endeffektor selbst in die Bewegungstrajektorie eingebunden sein, indem dieser eigene Stellelemente, z.B. Piezos, zum Ausrichten des Substrats aufweist.

Über die Kamera kann insbesondere das Einhalten der Zielposition während des Teach-In kontrolliert werden. Weiter kann über die Kamera das Einhalten der Zielposition auch während des Betriebs der Anlage fortlaufend kontrolliert werden.

So ist gemäß einer Ausführungsform der Erfindung vorgesehen mittels einer Bilderkennungssoftware das Einhalten der Zielposition fortlaufend zu überwachen und bei einer Abweichung von einer Sollposition das Teach-In der Bewegungskurve automatisch nachzujustieren.

Eine Nachjustierung des Teach-In kann insbesondere auch bei Überschreitung zumindest eines Grenzwerts einer Ist- von einer Sollposition (insbesondere der Lage des Substrats), und/oder gesteuert durch ein übergeordnetes Steuerungssystem und/oder manuell durch einen Bediener erfolgen.

Das Einhalten der Zielposition kann insbesondere anhand der Position des Wafers, der Maske oder des Flat-Panel-Displays gegenüber der Aufnahme bestimmt werden.

Denkbar ist dabei auch, dass die Aufnahme Markierungen umfasst, anhand welcher die Einhaltung der Zielposition besser, insbesondere automatisiert, kontrolliert werden kann.

Bei einer bevorzugten Ausführungsform der Erfindung wird die Kamera auch dazu verwendet, beim Vorgang des Teach-Ins die Position des Wafers, der Maske oder des Flat-Panel-Displays in Relation zur Aufnahme und/oder von Markierungen der Aufnahme zu überwachen und auf diese Weise bereits während des Vorgangs des Teach-Ins zu ermöglichen, dass die auf diese Weise geteachte Position einer Sollposition entspricht.

Die Kamera kann auch verwendet werden, um fortlaufend die aktuelle Position des Wafers, der Maske oder des Flat-Panel-Displays während der Bewegung des Roboters zu überwachen. So kann insbesondere das Teach-in ganz oder teilweise automatisch ausgeführt werden.

Insbesondere kann anhand der Zielposition eine Bewegungskurve berechnet und unter Kontrolle mittels der Kamera abgefahren werden.

Bei einer Ausführungsform der Erfindung kann die Kamera an einem Arm des Roboters, insbesondere an einem Endeffektor, angeordnet sein. Die Kamera kann auch im Arm, insbesondere im Endeffektor, integriert sein.

Über einen Endeffektor wird das Substrat, also der Wafer, die Maske oder das Flat-Panel-Substrat einer Bearbeitungsstation zugeführt. Insbesondere entnimmt der Endeffektor das Substrat einer Ablage. Der Endeffektor kann beispielsweise einen mechanischen Greifer umfassen. Aber auch beispielsweise elektrostatisch oder mittels Luftdruck das Substrat aufnehmende Endeffektoren können für die Erfindung verwendet werden.

Die Kamera ist vorzugsweise derart ausgerichtet, dass diese zumindest eine Kante oder zumindest teilweise einen Umriss des Wafers oder der Maske oder des Flat-Panel-Displays aufnimmt. Kommt es beispielsweise beim Ablegen oder Aufnehmen des Wafers mittels des Endeffektors zu einer abrupten Bewegungsänderung der Kante oder des Umrisses des Wafers, so kann darauf geschlossen werden, dass der Roboter beim Ablegen oder Aufnehmen des Wafers oder der Maske oder des Flat-Panel-Displays nicht optimal positioniert ist. Die Positionierung kann sowohl die Positionen in x-, y- und z-Richtung (translatorische Freiheitsgrade), als auch die Winkel in den drei rotatorischen Freiheitsgraden betreffen.

Weiterhin kann die Kamera so ausgerichtet sein, dass sowohl zumindest eine Kante oder ein Umriss oder ein anderer Referenzpunkt des Wafers, der Maske oder des Flat-Panel-Substrates, als auch die Aufnahme und/oder einer oder mehrerer Markierungen der Aufnahme aufgenommen werden. Auf diese Weise kann auch der Vorgang des Teach-Ins überwacht werden, so dass die auf diese Weise geteachte Position eine Sollposition entspricht.

Die Verwendung der Kamera ermöglicht erstmals auch den Teach-in-Vorgang automatisiert oder zumindest teilweise automatisiert durchzuführen. So kann beispielsweise über eine automatische Bilderkennung und eine Regelschleife die Position des Endeffektors beim Ablegen oder Aufnehmen des Wafers oder der Maske oder des Flat-Panel-Displays derart angepasst werden, dass es nicht zu einem abrupten Sprung in der Bewegung der Kante kommt.

Weiterhin ist es durch Verwendung der Kamera möglich, die Kontrolle des korrekten Teach-Ins während des Betriebes der Anlage auszuführen, wodurch Ausfallzeiten vermieden werden. Die Kamera kann also auch einer Prozesskontrolle dienen.

Die Kamera kann, wie es bei einer weiteren Ausführungsform der Erfindung vorgesehen ist, auch das gesamte Substrat, also die Maske, den Wafer, oder das Flat-Panel-Substrat, derart erfassen, dass sich dieses vollständig im Erfassungsbereich der Kamera befindet.

Bei einer weiteren Ausführungsform der Erfindung werden durch die durch die Kamera aufgenommenen Daten, oder darauf basierend durch eine Bildverarbeitung bearbeiteten Daten und/oder weiterverarbeiten Daten, Reaktionen in der Anlage initiiert und/oder an ein der Anlage übergeordnetes Steuerungssystem gesendet, insbesondere um die Anlage durch das übergeordnete Steuersystem zu überwachen.

Weiterhin können die durch die Kamera aufgenommenen Daten, oder darauf basierend durch eine Bildverarbeitung bearbeiteten Daten, oder auch weiterverarbeiten Daten, wie beispielsweise die Einhaltung definierter Grenzwerte von Positionen, eine Tendenz der Veränderungen von Positionen oder Auftreten von Vibrationen ermittelt werden, und in der Anlage zur Auslösung von Reaktionen, wie beispielsweise ein neues Teach-In, verwendet werden, und/oder an ein der Anlage übergeordnetes Steuerungssystem gesendet werden, insbesondere um die Anlage durch ein übergeordnetes Steuersystem zu überwachen.

Weiterhin kann durch Verwendung der Kamera vermieden werden, das Minienvironment der Anlage zu öffnen, wodurch zusätzliche Ausfallzeiten zur Wiederherstellung der Sauberkeit der Anlage vermieden werden.

Das von der Kamera aufgenommene Bild wird gemäß einer bevorzugten Ausführungsform der Erfindung auf ein Display, insbesondere auf ein Display eines tragbaren elektronischen Gerätes übertragen.

Das Bild kann so an beliebiger Position des Bedieners abgelesen werden. Insbesondere kann beispielsweise das Bild auch zusätzlich zu einer gleichzeitig durchgeführten visuellen Kontrolle verwendet werden.

Bei einer Weiterbildung der Erfindung werden mehrere, z.B. zwei, Kameras verwendet. Damit kann der Wafer, die Maske oder das Flat-Panel-Display bzw. dessen/deren Umriss zumindest teilweise, sowie und/oder die Aufnahme des Wafers, der Maske oder des Flat-Panel-Displays und/oder deren Markierungen aus mehreren Richtungen aufgenommen werden, was es ermöglicht, mehr Informationen über die Positionen oder Winkel zu erhalten, und auf diese Weise beispielsweise die Position in Relation zur Aufnahme in allen drei translatorischen und/oder rotatorischen Freiheitsgraden zu ermitteln.

Mit der zumindest einen Kamera wird insbesondere ein Versatz des Wafers oder der Maske oder des Flat-Panel-Displays gegenüber einer Sollposition gemessen.

Gemäß einer Ausführungsform der Erfindung wird die zumindest eine Kamera nur temporär angebracht, insbesondere unter Verwendung einer werkzeuglos anbringbaren Befestigung.

Bei dieser Ausführungsform der Erfindung ist also vorgesehen, dass ein Set mit einer Kamera bereitgestellt wird, welches temporär für den Teach-in-Vorgang verwendet und im Anschluss wieder abgebaut wird.

Gemäß einer anderen Ausführungsform der Erfindung ist es vorgesehen, dass die Kamera stationär in der Anlage verbleibt.

So kann die Kamera auch fortlaufend verwendet werden, beispielsweise, um den Roboter während des regulären Betriebs zu kontrollieren, oder das Teach-In ohne Öffnen des Minienvironments der Anlage vorzunehmen.

Die Kamera kann insbesondere in einer Vakuumkammer installiert sein.

Bei einer Weiterbildung der Erfindung wird ein Kamera-Modul mit einer integrierten Beleuchtung verwendet.

Eine weitere Ausführungsform verwendet eine Infrarotkamera.

Die Infrarotkamera wird gemäß einer Ausführungsform der Erfindung verwendet, um im Bewegungsbereich des Roboters und sich daraus ergebenden Sichtbereich der Kamera Messpunkte, zum Beispiel sich dort befindliche, auf die an dieser Stelle herrschende Temperatur temperierte Gegenstände anzufahren und deren Temperatur zu messen, oder um beispielsweise auch die Temperaturverteilung im Raum zu messen.

Die Infrarotkamera kann zur Messung der Temperatur der Maske, des Wafers oder des Flat-Panel-Displays, oder von Gegenständen in der Anlage zur Prozessierung von Halbleiterbauelementen verwendet werden.

Gemäß einer Ausführungsform wird die Infrarotkamera zusätzlich zu einer bildgebenden Kamera für den sichtbaren Wellenlängenbereich verwendet werden.

Das Bild der Kamera wird gemäß einer Ausführungsform der Erfindung drahtlos übertragen, insbesondere an ein tragbares elektronisches Gerät, wie beispielsweise ein Tablet.

Eine drahtlose Übertragung ist insbesondere bei der Ausführungsform des Verfahrens, bei welchem die Kamera nur temporär installiert wird, sinnvoll. Vorzugsweise wird dann auch eine Kamera mit integriertem Akku verwendet.

Bei dauerhaft eingesetzter Kamera erfolgt Bildübertragung und/oder Stromversorgung der Kamera vorzugsweise über Kabel.

Die Erfindung betrifft des Weiteren ein System, welches zur Ausführung des vorstehend beschriebenen Verfahrens ausgebildet ist.

Das System umfasst insbesondere eine Anlage zur Prozessierung von Halbleiterbauelementen.

Vorzugsweise umfasst das System eine Kamera, die auf einen Auflagepunkt eines Wafers oder Maskensubstrats oder eines Flat Panel Displays gerichtet ist.

So kann mittels der Kamera beobachtet werden, ob es beim Ablegen oder Aufnehmen des Wafers oder der Maske oder des Flat Panel Displays zu einem Versatz kommt, der auf eine Fehlpositionierung des Endeffektors hindeutet.

Die Kamera ist gemäß einer bevorzugten Ausführungsform der Erfindung am Endeffektor angeordnet, insbesondere in den Endeffektor integriert.

Gemäß einer weiteren Ausführungsform der Erfindung befindet sich eine Kamera an der der Aufnahme des Wafer- oder Maskensubstrats oder eines Flat-Panel-Displays und/oder im Chuck befindet.

### Kurzbeschreibung der Zeichnungen

Der Gegenstand der Erfindung soll im Folgenden bezugnehmend auf schematisch dargestellte Ausführungsbeispiele anhand der Zeichnungen Fig. 1 bis Fig. 6 näher erläutert werden.
Fig. 1 zeigt ein erstes Ausführungsbeispiel, bei welchem eine Kamera am Endeffektor angebracht ist.
Fig. 2 zeigt ein Ausführungsbeispiel, bei welchem eine Kamera an einer Aufnahme für einen Wafer oder eine Maske angeordnet ist.
Fig. 3 zeigt ein Ausführungsbeispiel, bei welchem zwei Kameras unmittelbar aneinander angrenzen und die Kanten eines Wafers oder einer Maske aufnehmen.
Fig. 4 zeigt ein Ausführungsbeispiel eines Endeffektors mit integrierter Kamera.
Fig. 4a zeigt ein Ausführungsbeispiel eines Endeffektors mit Kameras in den Armen.
Fig. 5 zeigt eine Anlage zur Prozessierung von Halbleiterbauelementen, bei welcher ein erfindungsgemäßer Endeffektor mit integrierter Kamera verwendet wird. Fig. 5a-5c zeigen die Anlage in verschiedenen Betriebszuständen.
Fig. 6 ist ein Flussdiagramm der Verfahrensschritte eines Ausführungsbeispiels des erfindungsgemäßen Verfahrens.

### Detaillierte Beschreibung der Zeichnungen

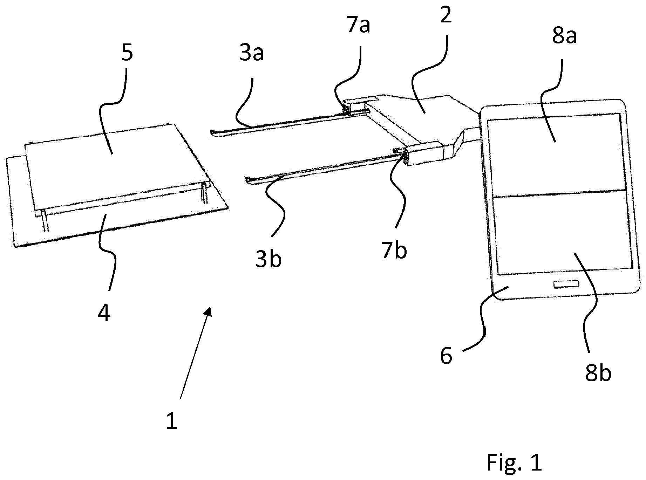

Fig. 1 zeigt in einer schematischen Ansicht ein System 1 zur Prozessierung von Halbeiterbauelementen.

Das System 1 umfasst einen Endeffektor 2 mit den Armen 3a, 3b, über die eine Maske 5 oder ein Wafer auf einer Ablage 4 abgesetzt und/oder aufgenommen werden kann.

Der Endeffektor ist Teil eines Roboters (nicht dargestellt) und wird über den Roboter in mehreren Raumrichtungen bewegt. Insbesondere kann ein Roboter mit einer Radial- und Theta-Achse verwendet werden.

Gemäß der Erfindung umfasst das System zumindest eine Kamera 7a, 7b, welche in diesem Ausführungsbeispiel mitbewegend am Endeffektor 2 angeordnet ist.

In diesem Ausführungsbeispiel sind zwei Kameras 7a, 7b vorgesehen.

Die Kameras 7a, 7b befinden sich in diesem Ausführungsbeispiel vorne am Endeffektor 2 zwischen oder neben den Armen 3a, 3b.

Das Bild der Kameras 7a, 7b wird an ein elektronisches Gerät, in diesem Ausführungsbeispiel an ein tragbares Tablet 6, übertragen.

In diesem Ausführungsbeispiel sind auf dem Tablet die Ansichten der Kameras 7a, 7b getrennt als Ansicht 8a und Ansicht 8b dargestellt. Die kann beispielsweise über einen geteilten Bildschirm realisiert sein.

Beispielsweise ist möglich, dass die Kamera 7a auf den Arm 3a gerichtet ist, wohingegen die Kamera 7b auf die vordere Kante der Maske 5 bzw. des Wafers gerichtet ist.

So kann zum einen über die Kamera 7a der Bewegungsverlauf des Endeffektors 2 kontrolliert werden.

Über die Kamera 7b kann auf einfache Weise festgestellt werden, wenn es zu einem Versatz beim Aufnehmen oder Ablegen der Maske 5 bzw. des Wafers kommt, oder ob sich die Maske bzw. der Wafer in der richtigen Position befindet.

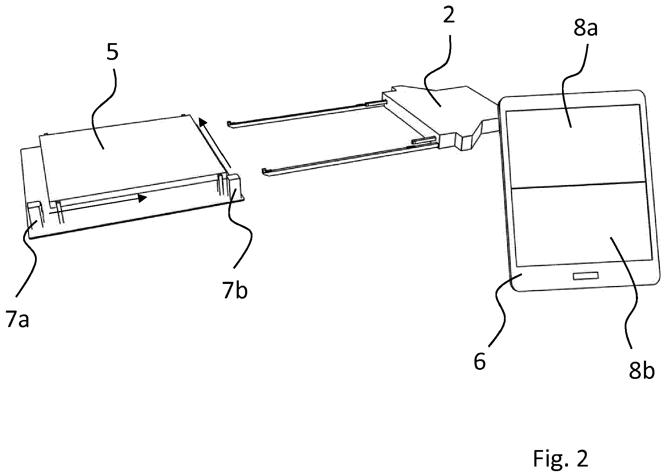

Fig. 2 zeigt schematisch ein alternatives Ausführungsbeispiel der Erfindung, bei welcher die zumindest eine Kamera nicht mitbewegend angeordnet ist.

In diesem Ausführungsbeispiel sind zwei Kameras 7a, 7b vorgesehen, welche jeweils entlang einer anderen Kante der Maske 5 bzw. des Wafers ausgerichtet sind. Die Blickrichtung der Kameras ist jeweils mit einem Pfeil gekennzeichnet.

Über die beiden Kameras 7a, 7b, deren Bild entsprechend der Ansichten 8a und 8b auf das Tablet 6 übertragen wird, kann auf einfache Weise erkannt werden, wenn es beim Aufnehmen oder Ablegen zum Versatz in eine Richtung kommt und/oder wenn die Zielposition von einer Sollposition abweicht.

Sofern es zu einem Versatz kommt, kann der Bediener beim Teach-in-Vorgang den Bewegungsablauf des Endeffektors 2 derart ändern, dass ein Versatz weitgehend vermieden wird.

Sowohl bei dem Ausführungsbeispiel gemäß Fig. 1 als auch bei dem Ausführungsbeispiel gemäß Fig. 2 kann die Kamera eine integrierte Beleuchtung aufweisen.

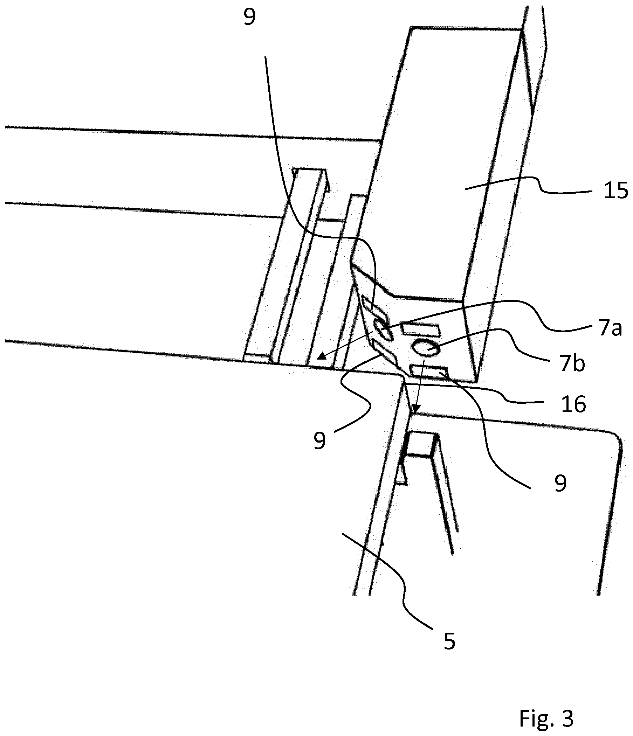

Fig. 3 zeigt ein Ausführungsbeispiel, bei welchem in einem einzigen Kameragehäuse 15 zwei Kameras an einer Ecke der Maske 5 bzw. des Wafers angeordnet sind.

Die Blickrichtungen der Kameras 7a, 7b sind mit einem Pfeil gekennzeichnet.

Zu erkennen ist, dass jede der Kameras 7a, 7b die von der Ecke 16 ausgehende Kante aufnimmt.

So kann ebenfalls auf einfache Weise ein Versatz beim Aufnehmen oder Ablegen festgestellt werden.

Vorzugsweise ist das Kameragehäuse 15 am Endeffektor angebracht.

Das Kameragehäuse 15 kann des Weiteren jeweils eine Beleuchtung 9 (z.B. LEDs) für das Sichtfeld der Kameras 7a, 7b umfassen.

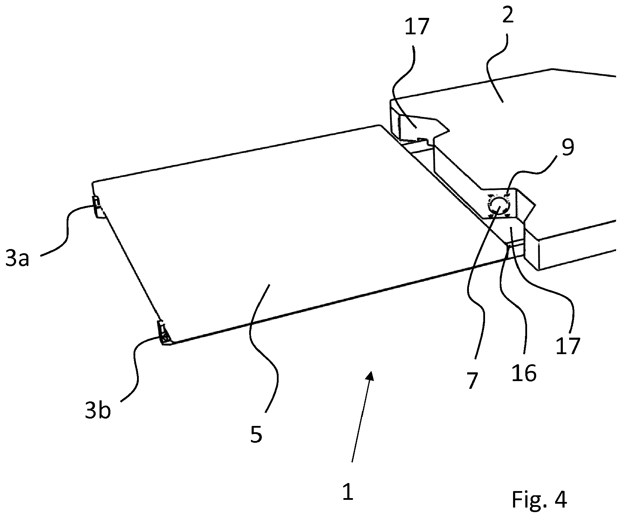

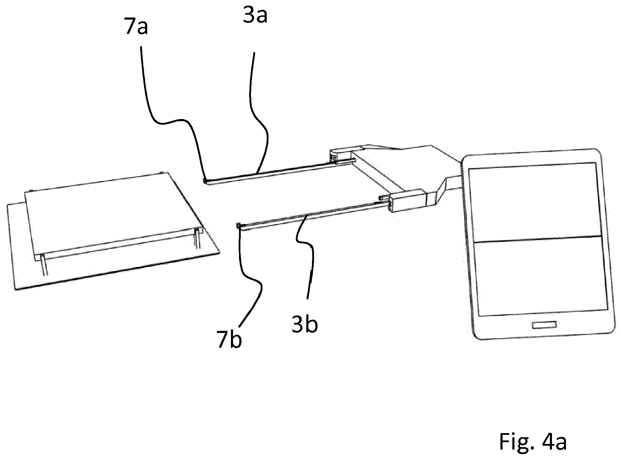

Fig. 4 zeigt ein Ausführungsbeispiel, bei welchem eine Kamera 7 mit integrierter Beleuchtung 9 im Endeffektor 2 integriert ist.

Hierzu umfasst der Träger des Endeffektors 2, aus welchem die Arme 3a, 3b hervorstehen, eine Einbuchtung 17, innerhalb der die Kamera 7 angeordnet ist. Die Kamera 7 ist bei dieser Ausführungsform der Erfindung schräg in das Gehäuse des Endeffektors 2 eingebaut.

So nimmt die Kamera 7, welche ein stabförmiges Gehäuse (nicht dargestellt) aufweisen kann, größtenteils ansonsten ungenutzten Raum im Gehäuse des Endeffektors 2 ein. Weiter kann durch die schräge Anordnung ein großes Sichtfeld bereitgestellt werden. Die optische Achse der Kamera 7 kann insbesondere einen Winkel von 30 bis 60° zur Haupterstreckungsrichtung der Arme 3a, 3b einnehmen.

Die zumindest eine Kamera 7 befindet sich in der Einbuchtung 17 in einer schräg verlaufenden Fläche, so dass die Kamera auf die Ecke 16 der Maske 5 bzw. des Wafers gerichtet ist.

Es versteht sich, dass in der zweiten Einbuchtung 17 vorzugsweise ebenfalls eine Kamera vorhanden ist oder sein kann, welche in dieser Ansicht verdeckt ist.

Fig. 4a zeigt eine weitere Ausführungsform der Erfindung, bei welcher die Kameras 7a und 7b an den Armen 3a, 3b des Endeffektors 2 angeordnet sind.

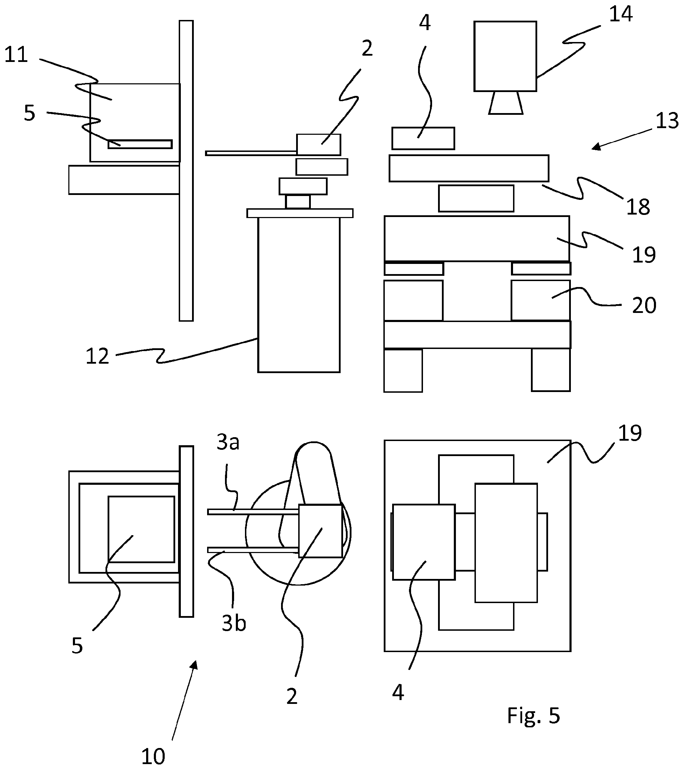

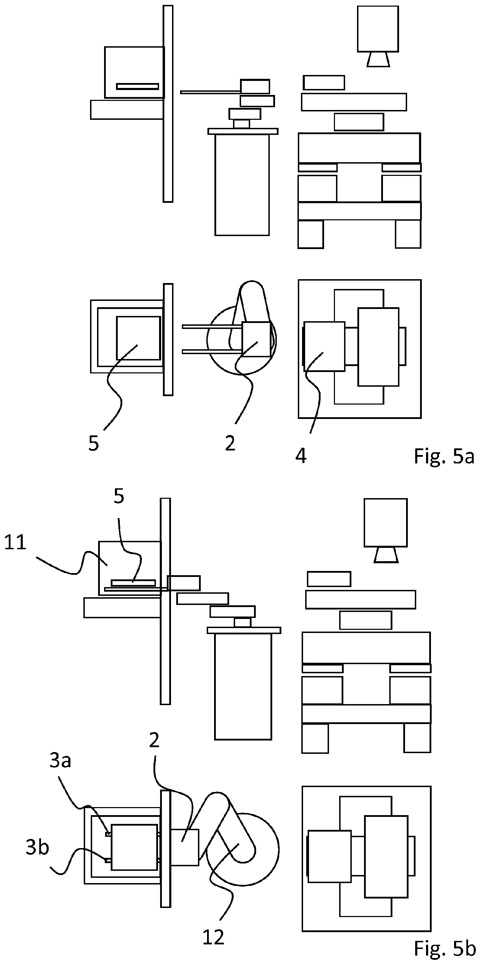

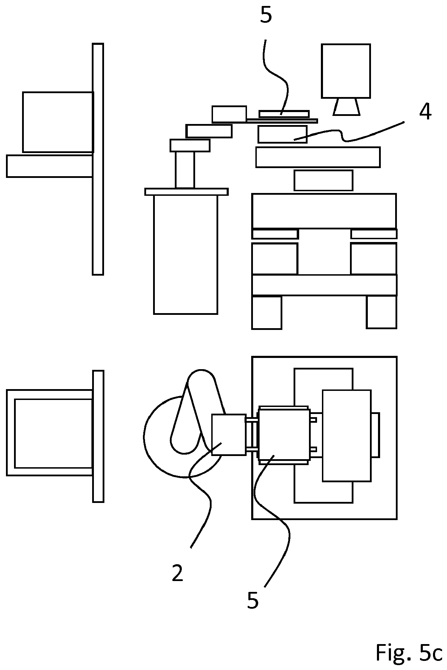

Fig. 5 zeigt in einer Seitenansicht und einer darunter dargestellten Draufsicht von oben wesentliche Bestandteile einer Anlage 10 zur Prozessierung von Halbleiterbauelementen.

Die Anlage 10 zur Prozessierung von Halbleiterbauelementen umfasst einen Behälter für Wafer oder im abgebildeten Fall für Masken 11, welcher im abgebildeten Fall insbesondere als FOUP (front opening unified pod) abgebildet ist, welcher mit einem SMIF (standard mechanical interface) Loadport geöffnet oder geschlossen wird.

In diesem Behälter 11 befinden sich die Substrate der zu prozessierenden Wafer 5 auf einer (nicht dargestellten) Aufnahme.

Mittels eines Roboters 12 mit dem Endeffektor 2 können dem Behälter 11 Substrate entnommen und an die Bearbeitungsstation 13 weitertransportiert werden.

Die Bearbeitungsstation 13 umfasst in diesem Ausführungsbeispiel eine verfahrbare Bühne 18 (Stage), auf welcher sich als Aufnahme für die Maske 5 ein Chuck befindet.

Die hier darstelle Maschine zur Prozessierung von Masken 5 kann insbesondere ein Inspektionsgerät 14 umfassen, welches sich auf einer Platte 19 befindet, die schwingungsisoliert von den Isolatoren 20 abgestützt wird.

Zumindest der Endeffektor 2 des Roboters 12 umfasst eine Kamera, mittels der der Roboter 12 auf einfache Weise angelernt und/oder kontrolliert werden kann.

Fig. 5a zeigt die in Fig. 5 dargestellte Anlage im Ruhezustand. Wie in Fig. 5a dargestellt, wird zur Aufnahme der Maske 5 aus dem Behälter 11, der Endeffektor mit seinen Armen 3a, 3b unter die Maske 5 gefahren.

Die Maske 5 wird mit dem Roboter 2 angehoben und in die Fig. 5c dargestellte Zielposition auf der Ablage 4 verfahren. Die Zielposition wird von der der am Endeffektor angeordneten Kamera kontrolliert.

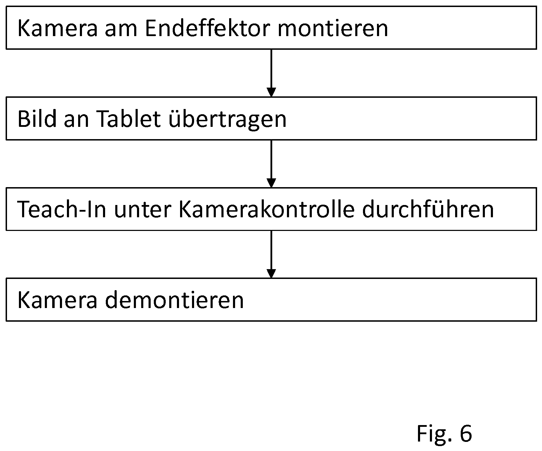

Fig. 6 zeigt schematisch wesentliche Schritte eines erfindungsgemäßen Verfahrens.

Zunächst wird eine Kamera an einem Endeffektor montiert. In einer anderen Ausführungsform ist die Kamera ständig am Endeffektor montiert.

Mittels der Kamera wird ein Bild während eines Teach-in-Vorgang an ein Tablet übertragen und der Teach-in-Vorgang wird unter Kamerakontrolle durchgeführt.

Im Anschluss wird die Kamera demontiert, nachdem das Teach-in fertiggestellt ist, sofern die Kamera nicht ständig am Endeffektor montiert ist.

Über die Verwendung einer Kamera kann eine Genauigkeit des Teach-Verfahrens von weniger als 50 µm erreicht werden, was gegenüber einer rein visuellen Kontrolle eine höhere Genauigkeit nach sich zieht.

Weiter kann das Kamerabild aufgenommen werden und so beispielsweise in Zeitlupe abgespielt werden, um den Teach-in-Vorgang zu optimieren.

Das Teach-in wird durch kontinuierliche Sicht auf die Ablagestation vereinfacht.

Weiter kann der Teach-in-Vorgang in der Regel durch eine einzige Person durchgeführt werden und es wird das Risiko von Beschädigungen während des Teach-ins reduziert.

Insbesondere ist auch ein Teach-in-Vorgang in einer geschlossenen Anlage, wie beispielsweise einer Vakuumkammer, auf einfachere Weise möglich. Die Verkleidung der Halbleiteranlage braucht bei Verwendung der Kamera nicht geöffnet zu werden.

Beispielsweise über Clips kann die Kamera werkzeuglos installiert werden.

Weiter kann mittels automatisierter Bildverarbeitung auch eine Positions- und Lageerkennung bereitgestellt werden.

Über geschlossene Regelkreise unter Verwendung der Positionserkennung einer mit der Kamera verbundenen Bilderkennungs-Software kann eine genauere Steuerung des Endeffektors erreicht werden. Beispielsweise kann für die Erfindung ein Endeffektor verwendet werden, bei welchem die Positionierung der Masken/Wafer oder Flat-Panel-Displays auf die Aufnahme durch im Endeffektor integrierte Motoren, beispielsweise mittels eines Piezos, erfolgt. So ist eine genauere Positionierung der Maske bzw. des Wafers oder Flat-Panel-Displays möglich, als über den entfernten Antrieb im Roboter.

Bei einer Ausführungsform der Erfindung umfasst also der Endeffektor selbst Aktoren zur Feinjustierung der Zielposition.

Auch der Roboter selbst kann, wie es bei einer Ausführungsform der Erfindung vorgesehen ist, über die Bilderkennung mittels der Kamera in seinem Bewegungsablauf feinjustiert werden.

Die Kamera kann ferner auch zur ständigen Anlagenüberwachung verwendet werden sowie zur Überwachung des Raums auf Hindernisse.

Alles in allem kann durch die Verwendung der Kamera insbesondere das Teach-in eines Roboters in erheblicher Weise vereinfacht werden.

### Bezugszeichenliste

- 1: System zur Prozessierung von Halbleiterbauelementen
- 2: Endeffektor
- 3a, 3b: Arm des Endeffektors
- 4: Aufnahme
- 5: Maske/Wafer
- 6: Tablet
- 7, 7a, 7b: Kamera
- 8a, 8b: Ansicht
- 9: Beleuchtung
- 10: Anlage zur Prozessierung von Halbleiterbauelementen
- 11: Behälter mit (nicht dargestellter) Aufnahme
- 12: Roboter
- 13: Bearbeitungsstation
- 14: Wafer-Inspektionsgerät
- 15: Kameragehäuse
- 16: Ecke
- 17: Einbuchtung
- 18: verfahrbare Bühne (Stage)
- 19: Platte
- 20: Isolator

## Patentansprüche

1. Verfahren zum Anlernen und/oder Kontrollieren eines Roboters zum Bewegen eines Wafers oder einer Maske, oder eines Flat-Panel-Displays, wobei zumindest eine Kamera verwendet wird, die die Bewegung des Roboters und/oder des Wafers oder der Maske oder des Flat-Panel-Displays aufnimmt.

2. Verfahren nach dem vorstehenden Anspruch, **dadurch gekennzeichnet, dass** mit der Kamera die aktuelle Position und/oder die Zielposition des Wafers, der Maske, oder des Flat-Panel-Displays auf einer Aufnahme, insbesondere auf einem Chuck oder einer anderen Station, kontrolliert wird.

3. Verfahren nach Anspruch 1, **dadurch gekennzeichnet, dass** die zumindest eine Kamera an einem Arm des Roboters, insbesondere an einem Endeffektor angebracht wird.

4. Verfahren nach einem der vorstehenden Ansprüche, **dadurch gekennzeichnet, dass** die Kamera für einen Teach-In Vorgang verwendet wird, insbesondere dass der Teach-In Vorgang automatisiert unter Verwendung der Kamera ausgeführt wird.

5. Verfahren nach einem der vorstehenden Ansprüche, **dadurch gekennzeichnet, dass** die Kamera auf zumindest eine Kante und/oder auf zumindest den teilweisen, insbesondere vollständigen, Umriss des Wafers oder der Maske oder des Flat-Panel-Displays beim Ablegen oder Aufnehmen des Wafers oder der Maske oder des Flat-Panel-Displays gerichtet wird.

6. Verfahren nach einem der vorstehenden Ansprüche, **dadurch gekennzeichnet, dass** das Bild der Kamera auf ein Display, insbesondere auf ein Display eines tragbaren elektronischen Geräts, übertragen wird, und/oder dass die zumindest eine Kamera nur temporär angebracht wird, insbesondere unter Verwendung einer werkzeuglos anbringbaren Befestigung, und/oder dass zumindest zwei Kameras verwendet werden.

7. Verfahren nach einem der vorstehenden Ansprüche, **dadurch gekennzeichnet, dass** mit der zumindest einen Kamera ein Versatz oder eine Position des Wafers oder der Maske oder des Flat-Panel-Displays gemessen wird.

8. Verfahren nach einem der vorstehenden Ansprüche, **dadurch gekennzeichnet, dass** die Kamera zur Prozesskontrolle, insbesondere zur fortlaufenden Kontrolle einer Zielposition, verwendet wird.

9. Verfahren nach einem der vorstehenden Ansprüche, **dadurch gekennzeichnet, dass** mittels der Kamera das Teach-In des Roboters, vorzugsweise automatisch, während des Betriebs fortlaufend nachjustiert wird, und/oder bei Überschreitung zumindest eines Grenzwerts und/oder gesteuert durch ein übergeordnetes Steuerungssystem und/oder manuell durch einen Bediener.

10. Verfahren nach einem der vorstehenden Ansprüche, **dadurch gekennzeichnet, dass** die Kamera verwendet wird, um Kollisionen mit Hindernissen im Bewegungsraum des Roboters zu vermeiden.

11. Verfahren nach einem der vorstehenden Ansprüche, **dadurch gekennzeichnet, dass** die Kamera in einer Vakuumkammer installiert wird und/oder dass das Bild der zumindest einen Kamera drahtlos übertragen wird, und/oder dass die durch die Kamera aufgenommenen Daten, oder darauf basierend durch eine Bildverarbeitung bearbeiteten Daten und/oder weiterverarbeiten Daten, Reaktionen in der Anlage initiieren und/oder an ein der Anlage übergeordnetes Steuerungssystem gesendet werden, insbesondere um die Anlage durch ein übergeordnetes Steuersystem zu überwachen,
und/oder dass ein Endeffektor verwendet wird, bei welchem die Positionierung der Maske, des Wafers oder des Flat-Panel-Displays auf die Aufnahme durch im Endeffektor integrierte Motoren, insbesondere Piezos, erfolgt,
und/oder dass ein Kameramodul mit einer integrierten Beleuchtung und/oder eine Infrarotkamera verwendet wird, wobei insbesondere mittels der Infrarotkamera die Temperatur der Maske, des Wafers oder des Flat-Panel-Displays oder deren Umgebung gemessen wird.

12. Verfahren nach einem der vorstehenden Ansprüche, **dadurch gekennzeichnet, dass** mittels einer automatisierten Bildverarbeitung eine Position des Wafers oder der Maske oder eines Flat-Panel-Displays bestimmt wird.

13. System, ausgebildet zur Ausführung eines Verfahrens nach einem der vorstehenden Ansprüche.

14. System nach dem vorstehenden Anspruch, **dadurch gekennzeichnet, dass** das System zumindest eine Kamera umfasst, die auf einen Auflagepunkt eines Wafer- oder Maskensubstrats oder eines Flat-Panel-Displays gerichtet ist.

15. System nach einem der vorstehenden Ansprüche, **dadurch gekennzeichnet, dass** sich die zumindest eine Kamera an einem Endeffektor und/oder an einer Aufnahme des Wafer- oder Maskensubstrats oder eines Flat-Panel-Displays und/oder im Chuck und/oder in einer Station, insbesondere Bearbeitungsstation des Systems, befindet.
